(19) Europäisches Patentamt
European Patent Office
Office européen des brevets

(11) **EP 3 218 738 B1**

(12) **FASCICULE DE BREVET EUROPEEN**

(45) Date de publication et mention de la délivrance du brevet:
**31.10.2018 Bulletin 2018/44**

(51) Int Cl.:
***G01S 7/02*** *(2006.01)*

(21) Numéro de dépôt: **15774548.0**

(86) Numéro de dépôt international:
**PCT/EP2015/071932**

(22) Date de dépôt: **24.09.2015**

(87) Numéro de publication internationale:
**WO 2016/074841 (19.05.2016 Gazette 2016/20)**

(54) **PROCEDE DE DETECTION DE SIGNAUX DANS UN RECEPTEUR NUMERIQUE AMBIGU EN FREQUENCES, ET RECEPTEUR NUMERIQUE METTANT EN OEUVRE UN TEL PROCEDE**

VERFAHREN ZUR SIGNALERFASSUNG BEI EINEM FREQUENZUNEINDEUTIGEN DIGITALEMPFÄNGER UND DIGITALEMPFÄNGER ZUR DURCHFÜHRUNG DIESES VERFAHRENS

METHOD FOR DETECTING SIGNALS IN A FREQUENCY-AMBIGUOUS DIGITAL RECEIVER, AND DIGITAL RECEIVER IMPLEMENTING SUCH A METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.11.2014 FR 1402548**

(43) Date de publication de la demande:
**20.09.2017 Bulletin 2017/38**

(73) Titulaire: **THALES**
**92400 Courbevoie (FR)**

(72) Inventeurs:
• **CORNIC, Pascal**
**F-29820 Guilers (FR)**
• **LE BIHAN, Patrick**
**F-29870 Lannilis (FR)**
• **FILLATRE, Joël**
**F-78590 Noisy-le-Roi (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**EP-A1- 1 618 407    EP-A1- 2 725 707**
**FR-A1- 2 897 441    FR-A1- 2 939 988**

• **YAGHOOBI MEHRDAD ET AL: "A low-complexity sub-Nyquist sampling system for wideband Radar ESM receivers", 2014 IEEE INTERNATIONAL CONFERENCE ON ACOUSTICS, SPEECH AND SIGNAL PROCESSING (ICASSP), IEEE, 4 mai 2014 (2014-05-04), pages 1788-1792, XP032618103, DOI: 10.1109/ICASSP.2014.6853906**
• **MCCORMICK: "A high resolution, near real-time frequency estimator for sub-microsecond pulses", SYSTEMS ENGINEERING, 1989., IEEE INTERNATIONAL CONFERENCE ON, IEEE, 1 janvier 1989 (1989-01-01), pages 33-38, XP032132227, DOI: 10.1109/ICSYSE.1989.48614**

**Description**

L'invention concerne un procédé de détection de signaux dans un récepteur numérique ambigu en fréquences. Elle concerne également un récepteur mettant en oeuvre un tel procédé. L'invention se situe notamment dans le domaine des récepteurs numériques à large bande.

Dans certaines applications, du fait des limitations technologiques des circuits de codage analogique-numérique, les récepteurs numériques utilisent des fréquences d'échantillonnage bien plus faibles que la bande totale de réception, par exemple une fréquence d'échantillonnage de l'ordre du GHz pour une bande totale à traiter comprise dans une bande de fréquences de l'ordre d'une dizaine de Ghz.

Dans ces conditions l'analyse spectrale, effectuée par filtrage numérique après échantillonnage et codage du signal, donne une mesure ambigüe de la fréquence du signal, du fait des repliements de spectre.

Pour traiter les repliements spectraux résultant du sous échantillonnage, ces récepteurs utilisent plusieurs voies de réception fonctionnant à des fréquences d'échantillonnage différentes. Il est alors possible de lever l'ambiguïté sur la mesure de fréquence à partir des différentes mesures de fréquences obtenues sur chacune des voies de réception, à condition que les fréquences d'échantillonnage soient choisies judicieusement et que le rapport signal à bruit soit suffisant pour permettre la détection du signal dans chaque voie de réception. Un tel dispositif est notamment décrit dans les documents EP1618407 A1 et FR 2897441 A1.

Dans les cas où le rapport signal à bruit en sortie du filtrage est insuffisant, la détection et a fortiori l'estimation de la fréquence du signal deviennent impossibles. C'est le cas par exemple lorsque le signal à détecter résulte d'une émission continue ou quasi continue à faible puissance crête.

Un problème à résoudre est notamment la détection ou la mesure de fréquence d'un signal à impulsion de longue durée et de faible puissance crête à partir d'un récepteur numérique à large bande de fréquence et à sous échantillonnages multiples.

Un but de l'invention est notamment de permettre la résolution d'un tel problème.

A cet effet, l'invention a pour objet un procédé de détection de signaux dans un récepteur numérique ambigu en fréquences par repliement des spectres de fréquences, ledit récepteur comportant au moins deux voies de réception, une fréquence d'échantillonnage desdits signaux étant propre à chaque voie, ledit procédé comporte au moins les étapes suivantes :

- déterminer une bande de recherche en fréquences bornée supérieurement par une fréquence $F_{max}$ inférieure ou égale à la moitié de la fréquence d'échantillonnage la plus petite parmi les fréquences d'échantillonnage desdites voies, ladite bande de recherche étant contenue dans un même rang d'ambiguïté vis-à-vis des fréquences d'échantillonnage desdites voies ;
- déterminer les fréquences d'échantillonnage desdites voies de façon à ce que les fréquences repliées correspondantes auxdites voies soient une fonction monotone de la fréquence vraie desdits signaux dans ladite bande de recherche ;
- filtrer numériquement lesdits signaux dans lesdites voies de réception dans des bancs de filtres de même fréquence centrale multiple d'une grandeur $1/T$ et de même largeur égale à ladite grandeur $1/T$, $Fech_l$ et $Fech_m$ étant respectivement la fréquence d'échantillonnage d'une voie d'ordre l et d'une voie d'ordre m quelconques parmi lesdites voies, $Fech_l/L = Fech_m/M = 1/T$, L et M étant des nombres entiers ;
- dans ladite bande de recherche, le repliement fréquentiel du signal dans la voie d'ordre l donnant une réponse dans le filtre de rang i et dans une voie d'ordre m une réponse dans le filtre de rang k+i ou i-k, réaliser un calcul d'inter-corrélation entre les signaux issus des filtres de rang i de fréquence centrale $Fech_l/L$ de la voie d'ordre l avec au moins les signaux issus des filtres de rang i+k ou i-k de la voie d'ordre m, de fréquence centrale $(i+k)Fech_m/M$ ou $(i-k)Fech_m/M$ ;
- réaliser la détection des signaux par comparaison de la puissance du signal en sortie du calcul d'inter-corrélation par rapport à un seuil donné, la fréquence d'un signal détecté étant identifiée par la connaissance des rangs desdits filtres.

Les fréquences d'échantillonnage desdites voies sont par exemple déterminées de façon à ce que les écarts entre les fréquences repliées correspondants auxdites voies soient constants dans ladite bande de recherche.

Le domaine de recherche en fréquences est par exemple déplacé en modifiant les fréquences d'échantillonnage desdites voies au cours du temps.

Avantageusement, lesdits signaux peuvent être des signaux de faible puissance crête et d'impulsion de longue durée.

Avantageusement, ledit procédé peut être appliqué à un goniomètre d'amplitude comprenant plusieurs antennes, au moins deux voies de réception étant connectées sur chaque antenne. Pour une antenne donnée, le calcul d'inter corrélation est par exemple effectué entre les signaux reçus sur les deux voies de réceptions de l'antenne, le résultat dudit calcul donnant accès à l'amplitude des signaux nécessaire à l'estimation de leur direction d'arrivée. Un calcul d'inter-corrélation par exemple est effectué entre les signaux reçus de deux antennes adjacentes.

Avantageusement, ledit procédé peut aussi être appliqué à un interféromètre ambigu en fréquence, une voie de réception étant reliée à chaque antenne dudit interféromètre. Chaque voie de réception étant associée à une antenne différente, la phase relative d'un signal est extraite à partir des différents calculs d'inter-corrélation effectués entre les différentes voies prises deux à deux.

Ledit procédé est par exemple effectué parallèlement à un traitement de détection adapté à la détection de signaux puisés.

L'invention a également pour objet un récepteur numérique mettant en oeuvre ledit procédé.

D'autres caractéristiques et avantages de l'invention apparaîtront à l'aide de la description qui suit, faite en regard de dessins annexés qui représentent :

- Les figures 1, 2 et 3, des exemples d'utilisation d'un récepteur numérique respectivement dans un goniomètre d'amplitude, dans un interféromètre et en association avec une antenne à formation de faisceau par le calcul ;
- La figure 4, une illustration du fonctionnement d'un récepteur numérique selon l'art antérieur ;
- La figure 5, une illustration de la variation de la fréquence ambigüe obtenue par repliement spectral numérique dans un récepteur ;
- La figure 6, une illustration d'un domaine fréquentiel de recherche particulier utilisé par l'invention ;
- La figure 7, une illustration du principe de fonctionnement d'un récepteur mettant en oeuvre le procédé de détection selon l'invention ;
- La figure 8, un exemple d'application de l'invention à un interféromètre ;
- La figure 9, un exemple d'application de l'invention à un goniomètre d'amplitude.

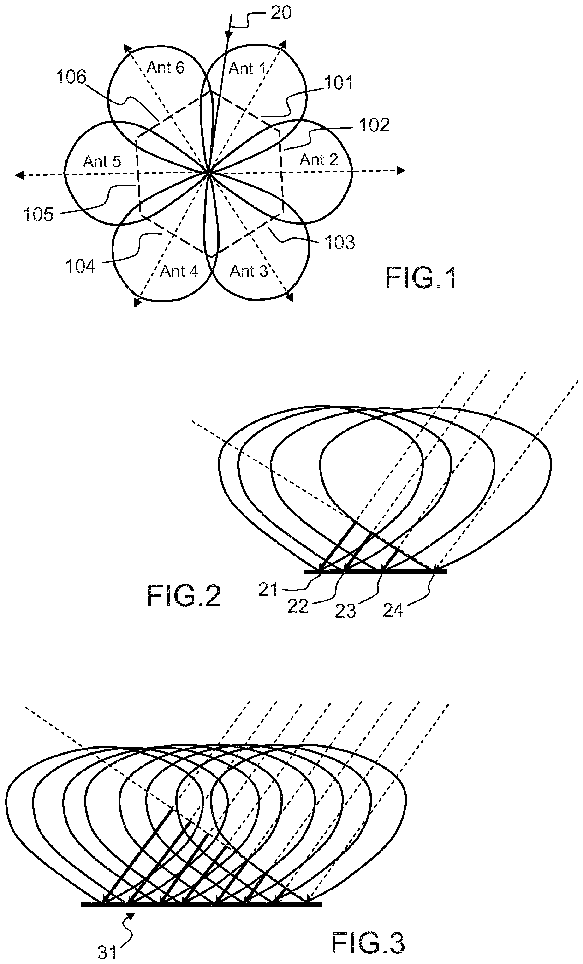

Les figures 1, 2 et 3 illustrent par des schémas de principe des exemples d'utilisation de récepteurs numériques. Ces récepteurs peuvent être associés indifféremment à des antennes à goniométrie d'amplitude, à des antennes interférométriques ou encore à des antennes de formation de faisceau par le calcul.

Dans le cas d'un réseau d'antennes à goniométrie d'amplitude comportant plusieurs antennes comme illustré par la figure 1, une configuration courante consiste à associer six antennes 101, 102, 103, 104, 105, 106 réparties en hexagone de façon à couvrir 360° dans le plan horizontal, chaque antenne ayant une ouverture de l'ordre de 60° à 90°. Dans un tel dispositif, la détection de la direction d'arrivée 20 d'un signal est obtenue à partir des amplitudes reçues sur les différentes antennes.

Dans le cas d'une antenne à interférométrie comme illustré par la figure 2, une configuration courante consiste à utiliser quatre antennes 21, 22, 23, 24 couvrant chacune de l'ordre de 90° en horizontal, espacées irrégulièrement pour former dans un plan donné une base interférométrique ambigüe. Une couverture de 360° peut être obtenue par exemple en utilisant quatre bases identiques de quatre antennes, les bases étant réparties selon les côtés d'un carré. Dans un tel dispositif, la direction d'arrivée d'un signal est estimée dans chaque secteur de 90° en exploitant les différences de phase du signal reçu sur les quatre antennes d'une même base.

Dans le cas d'une antenne à formation de faisceaux par le calcul comme illustré par la figure 3, on installe dans un plan donné plusieurs antennes 31 ayant généralement une ouverture de l'ordre de 90° en horizontal, les signaux reçus par ces différentes antennes étant sommés de façon cohérente après numérisation pour former simultanément plusieurs faisceaux directifs couvrant le domaine d'observation. Ce dispositif utilise également la phase du signal reçu sur les antennes pour estimer la direction d'arrivée, en comparant l'amplitude du signal reçu dans les faisceaux formés dans les directions adjacentes. Cette solution est peu utilisée en raison du volume de calculs à effectuer.

Pour tous ces dispositifs notamment, il faut résoudre le problème de la détection et de la mesure en fréquence des signaux de longue durée et de faible puissance crête à partir d'un récepteur numérique large bande à sous échantillonnage multiple. Actuellement, la sensibilité des récepteurs large bande, qu'ils soient analogiques ou numériques, est insuffisante pour détecter ces signaux de longue durée et de faible puissance crête.

Selon l'invention, on intègre dans un récepteur numérique large bande des moyens spécifiques permettant la détection des signaux de faible puissance crête et de longue durée en réalisant une inter corrélation des signaux reçus échantillonnés à des fréquences différentes, comme cela va être décrit par la suite.

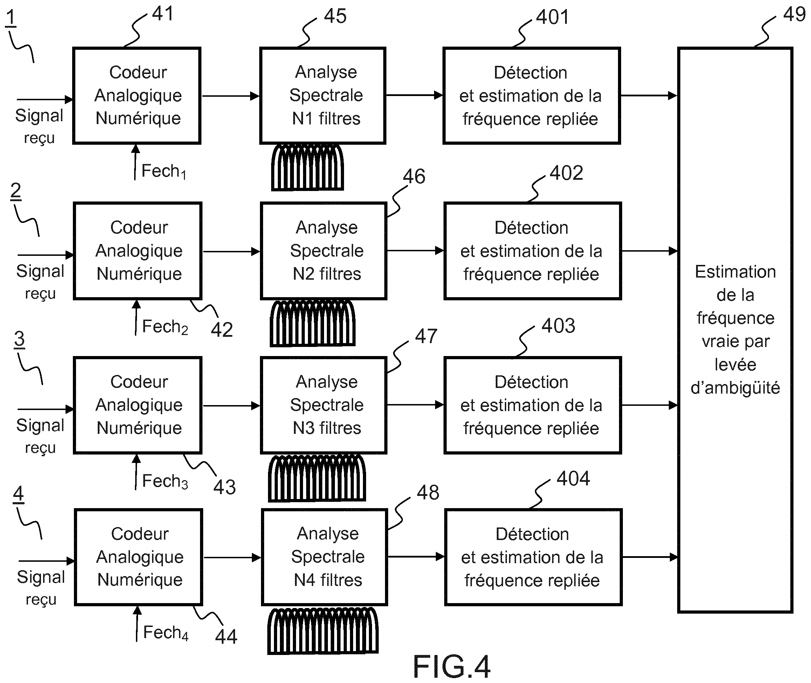

La figure 4 illustre le principe de fonctionnement d'un récepteur numérique selon l'art antérieur ayant une très large bande de réception, typiquement de 2 à 18 GHz. Le récepteur comporte quatre voies de réception 1, 2, 3, 4 ayant chacune en entrée un codeur analogique-numérique 41, 42, 43, 44. Les quatre fréquences d'échantillonnage $Fech_1$, $Fech_2$, $Fech_3$, $Fech_4$ des codeurs sont différentes, comprises par exemple entre 2 et 3 GHz, ce qui correspond à l'état de l'art pour les codeurs analogiques. Les quatre voies de réception peuvent être reliées à des antennes différentes ou non, selon le type de réseau d'antennes utilisé.

Dans un tel récepteur, les différentes fréquences $Fech_1$, $Fech_2$, $Fech_3$, $Fech_4$ sont choisies pour que l'ambiguïté sur la mesure de fréquence soit levée avec une marge de sécurité suffisante en présence de bruit, ce qui impose un espacement suffisant entre les différentes fréquences, typiquement de l'ordre de quelques dizaines de MHz. Ces différentes fréquences d'échantillonnage doivent également être choisies pour que leur plus petit commun multiple soit supérieur à la bande totale d'analyse des signaux reçus. Par ailleurs en raison du théorème de Shannon, la bande passante instantanée étant limitée à une valeur inférieure à la moitié de la fréquence d'échantillonnage la plus basse, les fréquences d'échantillonnage doivent être choisies les plus élevées possibles. Enfin, il est pratique d'utiliser un espacement constant $\delta F$ entre les fréquences d'échantillonnage car cela permet notamment d'utiliser des algorithmes simples pour lever les ambigüités en distance.

Ces contraintes et facilités conduisent par exemple à choisir des fréquences d'échantillonnage comme suit, M étant un nombre entier :

$$\text{Fech1} = M\delta F \ ; \ \text{Fech2} = (M+1)\delta F; \ \text{Fech3} = (M+2)\delta F; \ \text{Fech4} = (M+3)\delta F \qquad (1)$$

Par exemple si la fréquence d'échantillonnage des codeurs est de l'ordre de 2GHz, on peut choisir, en prenant M = 52 :

Fech1 = 2080 MHz, soit 52x40 MHz ;

Fech2 = 2120 MHz, soit 53x40 MHz ;

Fech3 = 2160 MHz, soit 54x40 MHz ;

Fech4 = 2200 Mhz, soit 55x40 MHz.

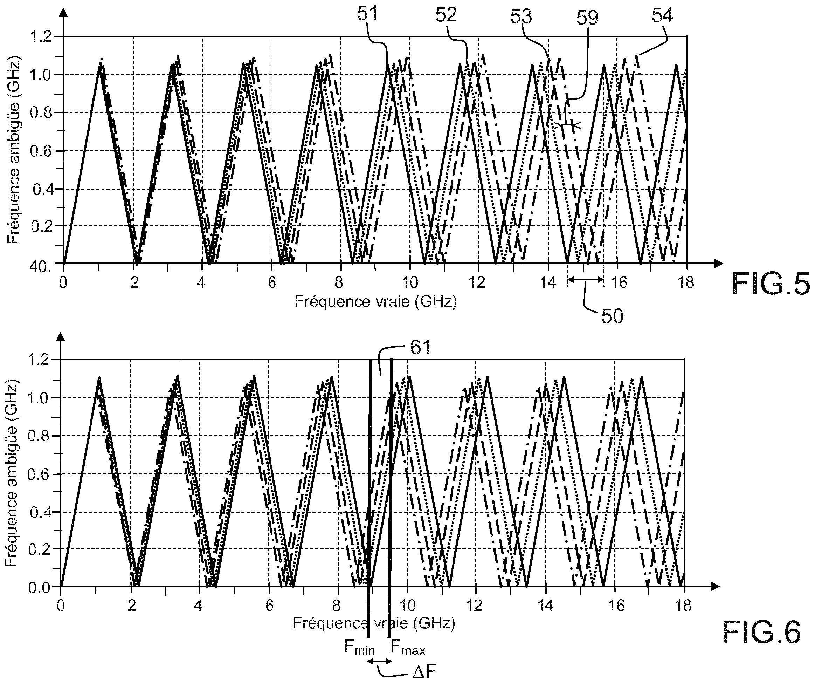

La figure 5 illustre la variation de la fréquence ambigüe obtenue par repliement spectral numérique en fonction de la fréquence du signal d'entrée, pour chacune des quatre fréquences d'échantillonnage de l'exemple ci-dessus, dans un système d'axes où les abscisses représentent la fréquence vraie des signaux reçus et les ordonnées la fréquence ambigüe détectée. Quatre courbes 51, 52, 53, 54 représentent les fréquences ambigües en fonction des fréquences vraies pour les quatre fréquences d'échantillonnage Fech1, Fech2, Fech3, Fech4.

Pour chaque fréquence d'échantillonnage, cette fréquence ambigüe, formant une fréquence repliée, peut s'écrire de la façon suivante :

$$\text{Famb}_i = \text{Fvraie} - \text{kamb}_i \ x \ \text{Fech}_i \qquad \text{si Fvraie} > \text{kamb}_i \ x \ \text{Fech}_i \qquad (1)$$

$$\text{Famb}_i = \text{kamb}_i \ x \ \text{Fech}_i - \text{Fvraie} \qquad \text{si Fvraie} < \text{kamb}_i \ x \ \text{Fech}_i \qquad (2)$$

où :

- Fvraie est la vraie fréquence du signal d'entrée du récepteur ;
- $\text{Fech}_i$ est la fréquence d'échantillonnage sur la voie i, i variant de 1 à 4 ;
- $\text{kamb}_i$ est le rang d'ambigüité, correspondant à la valeur entière de $(\text{Fvraie}/\text{Fech}_i) + 1/2$.

$\text{kamb}_i$ est donc égal à la valeur entière de $(\text{Fs}/\text{Fech}_i) + 1/2$, Fs étant la fréquence du signal reçu, en entrée du récepteur. La figure 5 montre en particulier que la mesure de fréquence obtenue après repliement sur les quatre voies de réception permet de déterminer sans ambigüité dans quelle sous-bande 50 se situe la fréquence du signal reçu, les écarts entre les fréquences repliées étant une fonction biunivoque du rang d'ambigüité, plus précisément un écart 59 caractérisant une sous-bande. Ainsi, connaissant cette sous-bande 50 et la fréquence ambigüe, on en déduit la fréquence vraie.

On revient à la figure 5. En pratique, l'analyse spectrale 45, 46, 47, 48 peut s'effectuer par exemple par transformée de Fourier numérique (DFT), ou encore à l'aide de filtres polyphasés. A partir de l'analyse spectrale, on effectue 401, 402, 403, 404 sur chaque voie la détection et l'estimation de la fréquence repliée, puis l'estimation 49 de la fréquence vraie du signal reçu par levée d'ambigüité.

Pour lever l'ambigüité et conserver la phase relative entre les voies 1, 2, 3, 4, on utilise la même résolution d'analyse sur les différentes voies. Par exemple, si on souhaite une résolution fréquentielle de 10 MHz, on peut choisir :

- Pour la fréquence d'échantillonnage $\text{Fech}_1$ = 2080 MHz, une DFT sur un nombre de points N1=208

- Pour la fréquence d'échantillonnage $Fech_2$ = 2120 MHz, une DFT sur un nombre de points N2=212

- Pour la fréquence d'échantillonnage $Fech_3$ = 2160 MHz, une DFT sur un nombre de points N3=216

- Pour la fréquence d'échantillonnage $Fech_4$ = 2200 MHz, une DFT sur un nombre de points N4=220

ce qui correspond à :

$$Fech_1/N1 = Fech_2/N2 = Fech_3/N3 = Fech_4/N4 = 1/T, \qquad (3)$$

T étant la durée de la fenêtre d'observation, 1/T étant égal à 10 MHz dans cet exemple.
Ce mode de détection et d'estimation de la fréquence du signal telle que décrite ci-dessus relativement à la figure 5 est mis en échec lorsque le rapport signal sur bruit est insuffisant pour permettre la détection 401, 402, 403, 404 dans chaque voie de réception élémentaire.
De plus la fréquence du signal d'entrée du récepteur étant inconnue, il n'est pas possible de connaître la façon dont les repliements 51, 52, 53, 54 s'effectuent et donc les filtres dans lesquels le signal est présent sur les différentes voies 1, 2, 3, 4. Ceci interdit a priori les possibilités de recombinaison des signaux reçus entre les différentes voies visant à augmenter le rapport signal sur bruit, pour permettre la détection. C'est le cas en particulier en présence de signaux longs de faible puissance crête.
La figure 6 illustre une caractéristique de l'invention.
Selon l'invention à partir d'un domaine fréquentiel 61 déterminé et limité dans lequel on souhaite chercher à détecter une émission continue ou à impulsions longue, de faible puissance crête, on choisit les différentes fréquences d'échantillonnage de façon à ce que les écarts entre fréquences repliées correspondant aux différentes voies de réception 1, 2, 3, 4 soient constants dans ce domaine fréquentiel déterminé 61.
Ceci est obtenu, si :

- Premièrement, le rang d'ambiguïté de la fréquence obtenue après repliement est identique pour toutes les fréquences d'échantillonnage, à l'intérieur du domaine fréquentiel de recherche. En d'autres termes, le domaine de recherche 61 est contenu dans un même rang d'ambiguïté vis-à-vis des fréquences d'échantillonnage des différentes voies. Dans l'exemple de la figure 6, il faut :

  ∘ $kamb_1 = kamb_2 = kamb_3 = kamb_4 = kamb$,

  soit :

  ∘ valeur entière $(Fvraie/Fech_1)$ = valeur entière $(Fvraie/Fech_2)$ = valeur entière $(Fvraie/Fech_3)$ = valeur entière $(Fvraie/Fech_4)$

- Deuxièmement, dans l'intervalle correspondant au domaine fréquentiel de recherche, si la fréquence ambiguë est une fonction monotone de la fréquence vraie de même sens de variation pour les différentes fréquences d'échantillonnage.

Pour toute valeur de fréquence vraie, Fvraie, contenue dans le domaine de fréquence 61 défini par des bornes $F_{min}$, $F_{max}$, on a alors :

- Pour un sens de variation croissant, c'est à dire pour les valeurs entières de kamb :

$$F_{min} \geq kamb \times Fech_{max} \qquad et \qquad F_{max} < ( kamb+1/2 ) \times Fech_{min}$$

- Pour un sens de variation décroissant :

$$F_{min} \geq (kamb+1/2) \times Fech_{max} \qquad et \qquad F_{max} < (kamb+1) \times Fech_{min}$$

$Fech_{min}$ est la plus petite des fréquences d'échantillonnage des différentes voies. Dans le présent exemple,

$Fech_{min}$ est $Fech_1$. De même, $Fech_{max}$ est la plus grande des fréquences d'échantillonnage, $Fech_{max}$ est $Fech_4$.

Par exemple, en choisissant le sens de variation croissant de la fréquence ambiguë, on peut choisir :

$$Fech_{max} \geq F_{min}/kamb$$

Pour un domaine de fréquence limité 61 à $\Delta F$, il vient :
$\Delta F \leq F_{max} - F_{min}$, SOit :

$$\Delta F \leq kamb \times (Fech_{min}-Fech_{max})+Fech_{min}/2$$

Et en utilisant la relation (3), on obtient pour quatre fréquences d'échantillonnage :

$$\Delta F \leq (\frac{M}{2} - 3kamb)\delta F$$

Par exemple, si la borne basse du domaine de recherche est fixée à $F_{min} = 9$ GHz, on peut choisir, compte-tenu des fréquences d'échantillonnage maximales accessibles de l'ordre de 2 GHz, en prenant comme pas en fréquence d'échantillonnage $\delta F = 40$ MHz :

- Kamb = 4

- $Fech_4 = Fech_{max}= (M+3)\delta F$ l'entier le plus proche de $F_{min}/Kamb=2,25$ GHz, soit 56x40 MHz=2,24 GHz

avec :
M+3=56, soit M=53
D'où :

- $Fech_3 = 55$ x40 MHz = 2,2 GHz ;
- $Fech_2 = 54$x40 MHz = 2,16 GHz ;
- $Fech_1 = 53$x40 MHz = 2,12 GHz.

Et pour un domaine de recherche en fréquence borné par $\Delta F \leq 580$ *MHz,* on obtient $F_{max} = 9,58$ GHz.
Après avoir fixé les fréquences d'échantillonnage conformément à ce qui précède, on détermine dans une étape suivante l'écart des fréquences repliées entre les différentes voies de réception 1, 2, 3, 4 dans le domaine de recherche 61.
Dans ce domaine 61, en ne retenant que l'hypothèse de la fréquence repliée monotone croissante comme illustré par la figure 6, on obtient :

$$Fvraie=kamb\ Fech_1+i_1\ Fech_1/N1$$

$$Fvraie=kamb\ Fech_2+i_2\ Fech_2/N2$$

$$Fvraie=kamb\ Fech_3+i_3\ Fech_3/N3$$

$$Fvraie =kamb\ Fech_4+i_4\ Fech_4/N4$$

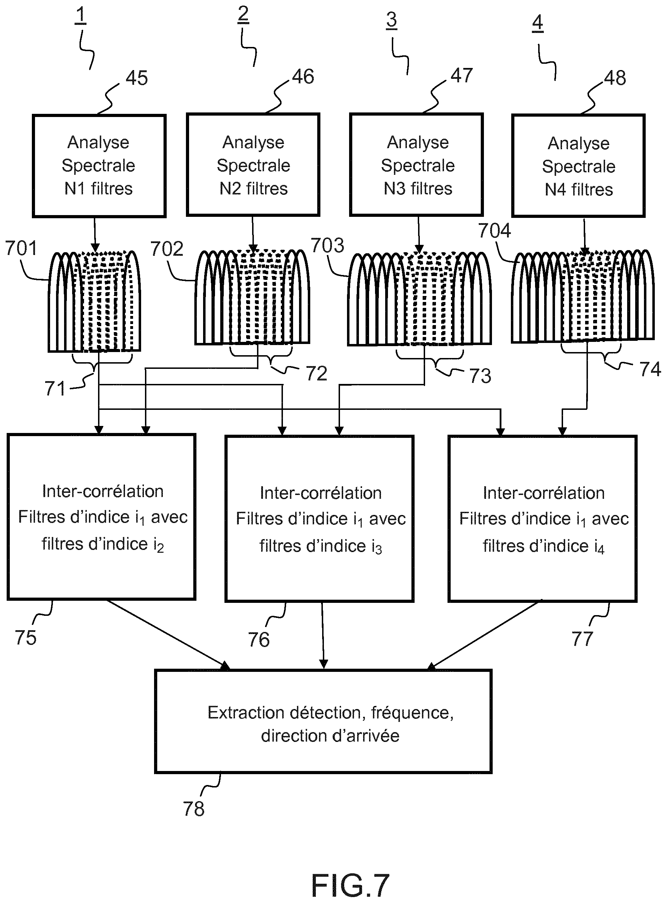

où $i_1$, $i_2$, $i_3$, $i_4$ représentent les indices, ou les rangs, des filtres 71, 72, 73, 74 respectivement des voies 1, 2, 3 et 4 dans lesquels se replie le signal d'entrée, N1, N2, N3, N4 ayant été définis précédemment. Ces filtres sont illustrés dans le schéma de la figure 7 présentant ces quatre voies. Ces filtres 71, 72, 73, 74 sont contenus dans des bancs de filtres 701, 702, 703, 704. L'analyse spectrale peut être obtenue au travers d'une transformée de Fourier direct (TFD) ou de filtres polyphasés. En d'autres termes, les bancs de filtres peuvent être du type TFD ou polyphasés par exemple.

Selon la relation (3) précisant que :

$Fech_1/N1 = Fech_2/N2 = Fech_3/N3 = Fech_4/N4 = 1/T$ il vient :

$$i_2 - i_1 = -kamb. \, \delta F. \, T$$

$$i_3 - i_1 = -2 \, kamb. \, \delta F. \, T$$

$$i_4 - i_1 = -3 \, kamb. \, \delta F. \, T$$

Par exemple pour l'exemple précédent, si la résolution d'analyse spectrale est fixée à 10 MHz, correspondant à T=100 ns, pour kamb=4 et $\delta F$=40 MHz :

$i_2 - i_1 = -16$
$i_3 - i_1 = -32$
$i_4 - i_1 = -48$

Connaissant le rang $i_1$ concerné dans le premier banc de filtres 701, on en déduits les rangs $i_2$, $i_3$, $i_4$ des filtres concernés dans les autres bancs 702, 703, 704.

Ayant ainsi identifié les différences d'indice des filtres concernés 71, 72, 73, 74, une étape suivante consiste à effectuer des inter corrélations complexes 75, 76, 77 des signaux issus de ces filtres entre les différentes voies.

Cette inter corrélation est effectuée sur un temps long, typiquement de l'ordre de 100 microsecondes, conformément au type d'inter corrélation décrite par exemple dans la demande de brevet FR1400514 publiée le 04.09.2015 sous le numéro FR3018136. Elle permet non seulement d'obtenir un rapport signal à bruit suffisant pour la détection, mais aussi d'extraire la différence de phase entre les voies de réception, par exemple dans le cas d'un interféromètre, ou bien la différence d'amplitude entre deux antennes adjacentes, dans le cas d'un goniomètre d'amplitude.

Dans ce processus, la sortie du filtre d'indice $i_1$ de la voie 1 sera corrélée avec la sortie du filtre d'indice $i_2$ de la voie 2 et par exemple, pour 4 voies de réception, la sortie du filtre $i_1$ de la voie 1 sera également corrélée avec la sortie du filtre $i_3$ de la voie 3 et $i_4$ de la voie 4, comme l'illustre l'exemple de la figure 7.

Ce processus est effectué pour tous les indices de filtres dont les fréquences centrales sont contenues dans le domaine de recherche.

Dans une étape suivante 78, les résultats des inter corrélations sont ensuite comparés en amplitude à un seuil pour assurer la détection des signaux et identifier les indices des filtres correspondant au signal afin d'en estimer la fréquence. L'amplitude et la phase des inter corrélations sont également mémorisées à ce niveau, par exemple pour extraire la direction d'arrivée du signal.

Après avoir ainsi exploité un domaine de recherche 61, il est ainsi possible de choisir un nouveau domaine en définissant un nouveau jeu de fréquences d'échantillonnage.

L'invention a été décrite à titre d'exemple pour un récepteur numérique à quatre voies. Elle s'applique plus généralement pour un récepteur comportant au moins deux voies différentes correspondant à des fréquences d'échantillonnage $Fech_l$, $Fech_m$ différentes dans des bancs de filtres 701, 702, 703, 704 de même fréquence centrale multiple d'une grandeur 1/T, où $1/T = Fech_l/L = Fech_m/L$, et de mêmes largeurs $1/T = Fech_l/L = Fech_m/L$, L et M étant des nombres entiers, T étant la durée de la fenêtre d'observation.

Avantageusement, l'invention peut notamment être appliquée à un interféromètre ou à un récepteur à goniométrie d'amplitude.

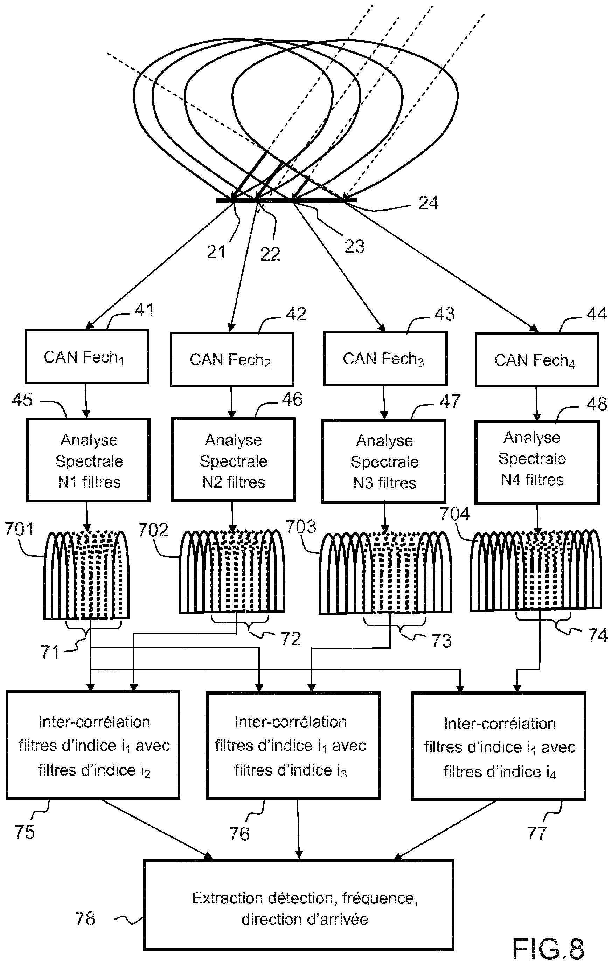

La figure 8 illustre l'application à un interféromètre. Le système illustré par la figure 7 est connecté, en réception, aux antennes 21, 22, 23, 24 du dispositif de la figure 2. Plus précisément, des codeurs 41, 42, 43, 44 reçoivent chacun en entrée un signal issu d'une antenne 21, 22, 23, 24, éventuellement via une interface non représentée. Conformément à la description précédente, un premier codeur 41 échantillonne à la fréquence $Fech_1$, un deuxième codeur à la fréquence $Fech_2$, un troisième codeur à la fréquence $Fech_3$ et un quatrième codeur à la fréquence $Fech_4$, les fréquences étant préférentiellement différentes.

Les signaux numériques issus des codeurs sont ensuite traités conformément au procédé selon l'invention, en sortie d'analyses spectrales 45, 46, 47, 48. L'inter corrélation telle que décrite ci-dessus s'effectue notamment entre le signal reçu de la première antenne 21 avec les signaux reçus des autres antennes 22, 23, 24, le filtre d'indice $i_1$ étant associé à la première voie de réception reliée à la première antenne 21. En d'autres termes, chaque voie de réception, de fréquence d'échantillonnage différente, étant associée à une antenne différente, on extrait la phase relative des signaux à partir des différents calculs d'inter corrélation effectués entre les différentes voies prises deux à deux. La direction d'arrivée des signaux est obtenue à l'aide de cette phase.

Les levées d'ambiguïté de la mesure de fréquence et de la mesure de phase d'interférométrie sont ainsi effectuées en une seule opération résultant des produits d'inter corrélation, comme décrit relativement à la figure 7.

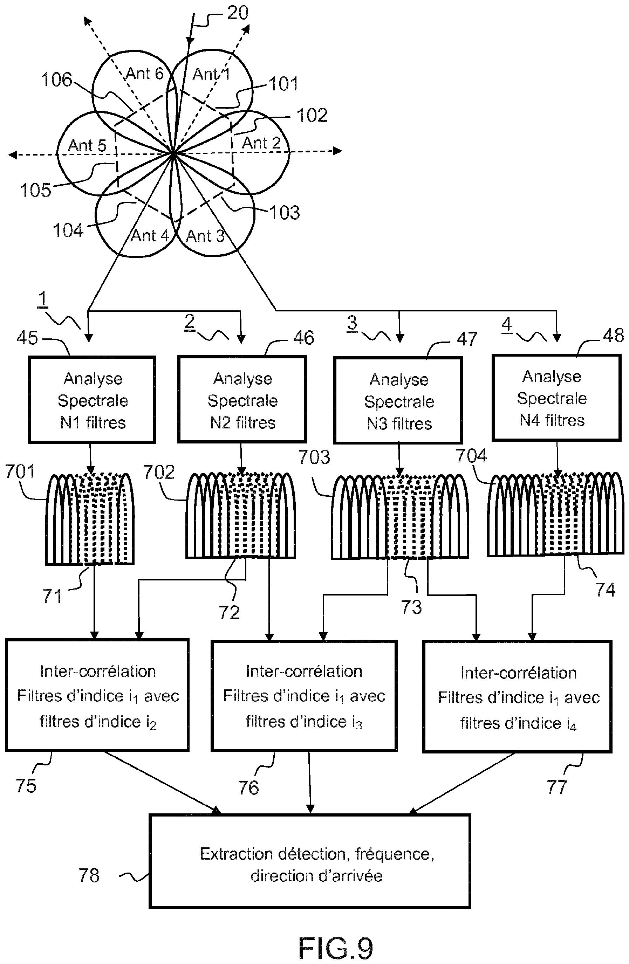

La figure 9 illustre l'application à un goniomètre d'amplitude tel qu'illustré par la figure 1. Dans un mode de réalisation particulier, au moins deux voies de réception 1, 2 fonctionnant à deux fréquences d'échantillonnage sont connectées sur chaque antenne 101, 102, 103, 104, 105, 106. Pour des raisons de clarté, sur la figure 9, seules deux antennes 103, 104 sont reliées à des voies de réceptions, chacune étant reliée à deux voies de réception.

Sur une antenne donnée 104, l'inter corrélation est effectuée sur deux voies 1, 2 de fréquences d'échantillonnage différentes. Ce calcul d'inter corrélation donne accès à la mesure d'amplitude du signal nécessaire à l'estimation de la direction d'arrivée. La levée d'ambiguïté sur la mesure de fréquence s'effectue par exemple à l'aide des signaux repliés en fréquence, obtenus à partir du même signal échantillonné à l'aide de deux paires de fréquence différente. Ce signal peut provenir d'une même antenne 104, ou deux antennes adjacentes 103, 104 le recevant simultanément. La couverture sur 360° est obtenue à l'aide de 12 voies de réception pour un dispositif goniométrique à 6 antennes, chaque antenne étant reliée à deux voies.

## Revendications

1. Procédé de détection de signaux dans un récepteur numérique ambigu en fréquences par repliement des spectres de fréquences, ledit récepteur comportant au moins deux voies de réception (1, 2, 3, 4), **caractérisé en ce qu'**une fréquence d'échantillonnage desdits signaux étant propre à chaque voie, ledit procédé comporte au moins les étapes suivantes :

   - déterminer une bande de recherche en fréquences (61) bornée supérieurement par une fréquence ($F_{max}$) inférieure ou égale à la moitié de la fréquence d'échantillonnage la plus petite parmi les fréquences d'échantillonnage desdites voies, ladite bande de recherche étant contenue dans un même rang d'ambiguïté vis-à-vis des fréquences d'échantillonnage desdites voies ;
   - déterminer les fréquences d'échantillonnage desdites voies (1, 2, 3, 4) de façon à ce que les fréquences repliées correspondantes auxdites voies soient une fonction monotone de la fréquence vraie desdits signaux dans ladite bande de recherche (61) ;
   - filtrer numériquement lesdits signaux dans lesdites voies de réception (1, 2, 3, 4) dans des bancs de filtres (701, 702, 703, 704) de même fréquence centrale multiple d'une grandeur $1/T$ et de même largeur égale à ladite grandeur $1/T$, $Fech_l$ et $Fech_m$ étant respectivement la fréquence d'échantillonnage d'une voie d'ordre $l$ et d'une voie d'ordre $m$ quelconques parmi lesdites voies (1, 2, 3, 4), $Fech_l/L = Fech_m/M = 1/T$, $L$ et $M$ étant des nombres entiers ;
   - dans ladite bande de recherche (61), le repliement fréquentiel du signal dans la voie d'ordre $l$ donnant une réponse dans le filtre de rang $i$ (71) et dans une voie d'ordre $m$ une réponse dans le filtre de rang $k+i$ ou $i-k$ (72, 73, 74), réaliser un calcul d'inter-corrélation (75, 76, 77) entre les signaux issus des filtres de rang $i$ (71) de fréquence centrale $Fech_l/L$ de la voie d'ordre $l$ avec au moins les signaux issus des filtres de rang $i+k$ ou $i-k$ (72, 73, 74) de la voie d'ordre $m$, de fréquence centrale $(i+k)Fech_m/M$ ou $(i-k)Fech_m/M$ ;
   - réaliser la détection (78) des signaux par comparaison de la puissance du signal en sortie du calcul d'inter-corrélation par rapport à un seuil donné, la fréquence d'un signal détecté étant identifiée par la connaissance des rangs desdits filtres.

2. Procédé selon la revendication 1, **caractérisé en ce que** les fréquences d'échantillonnage desdites voies (1, 2, 3, 4) sont déterminées de façon à ce que les écarts entre les fréquences repliées correspondants auxdites voies soient constants dans ladite bande de recherche (61).

3. Procédé selon l'une quelconque des revendications précédentes, **caractérisé en ce que** ledit domaine de recherche en fréquences (61) est déplacé en modifiant les fréquences d'échantillonnage desdites voies (1, 2, 3, 4) au cours du temps.

4. Procédé selon l'une quelconque des revendications précédentes, **caractérisé en ce que** lesdits signaux sont des signaux de faible puissance crête et d'impulsion de longue durée.

5. Procédé selon l'une quelconque des revendications précédentes, **caractérisé en ce qu'**il est appliqué à un goniomètre d'amplitude comprenant plusieurs antennes (101, 102, 103, 104, 105, 106), au moins deux voies de réception (1, 2, 3, 4) étant connectées sur chaque antenne.

6. Procédé selon la revendication 5, **caractérisé en ce que** pour une antenne donnée (104), le calcul d'inter corrélation est effectué entre les signaux reçus sur les deux voies de réceptions (1, 2) de l'antenne, le résultat dudit calcul donnant accès à l'amplitude des signaux nécessaire à l'estimation de leur direction d'arrivée.

7. Procédé selon l'une quelconque des revendications 5 ou 6, **caractérisé en ce qu'**un calcul d'inter-corrélation est effectué entre les signaux reçus de deux antennes adjacentes (103, 104).

8. Procédé selon l'une quelconque des revendications précédentes, **caractérisé en ce qu'**il est appliqué à un interféromètre ambigu en fréquence, une voie de réception (1, 2, 3, 4) étant reliée à chaque antenne (21, 22, 23, 24) dudit interféromètre.

9. Procédé selon la revendication 8, **caractérisé en ce que** chaque voie de réception (1, 2, 3, 4) étant associée à une antenne différente (21, 22, 23, 24), la phase relative d'un signal est extraite à partir des différents calculs d'inter-corrélation effectués entre les différentes voies prises deux à deux.

10. Procédé selon l'une quelconque des revendications précédentes, **caractérisé en ce qu'**il est effectué parallèlement à un traitement de détection adapté à la détection de signaux puisés.

11. Récepteur numérique, **caractérisé en ce qu'**il met en oeuvre le procédé selon l'une quelconque des revendications précédentes.

**Patentansprüche**

1. Verfahren zum Erkennen von Signalen in einem frequenzuneindeutigen digitalen Empfänger durch Falten von Frequenzspektren, wobei der Empfänger wenigstens zwei Empfangskanäle (1, 2, 3, 4) umfasst, **dadurch gekennzeichnet, dass** eine Abtastfrequenz der Signale jedem Kanal eigen ist, wobei das Verfahren wenigstens die folgenden Schritte beinhaltet:

   - Bestimmen eines Frequenzsuchbandes (61), das oben durch eine Frequenz ($F_{max}$) gleich oder kleiner als die Mitte der kleinsten Abtastfrequenz unter den Abtastfrequenzen der Kanäle begrenzt ist, wobei das Suchband in einem selben Ambiguitätsrang gegenüber den Abtastfrequenzen der Kanäle enthalten ist;
   - Bestimmen der Abtastfrequenzen der Kanäle (1, 2, 3, 4) auf eine solche Weise, dass die den Kanälen entsprechenden gefalteten Frequenzen eine monotone Funktion der wahren Frequenz der Signale in dem Suchband (61) sind;
   - digitales Filtern der Signale in den Empfangskanälen (1, 2, 3, 4) in Filtergruppen (701, 702, 703, 704) mit derselben zentralen Mittelfrequenz, die ein Mehrfaches einer Größe 1/T ist, und mit derselben Breite gleich der Größe 1/T, wobei $Fech_l$ und $Fech_m$ jeweils die Abtastfrequenz eines Kanals der Größenordnung l und eines Kanals der Größenordnung m unter den Kanälen (1, 2, 3, 4) ist, wobei $Fech_l$/L = $Fech_m$/M = 1/T ist, wobei L und M ganze Zahlen sind;
   - wobei in dem Suchband (61) die Frequenzfaltung des Signals in dem Kanal der Größenordnung l eine Antwort in dem Filter von Rang i (71) gibt und in einem Kanal der Größenordnung m eine Antwort in dem Filter von Rang k+i oder i-k (72, 73, 74) gibt, Durchführen einer Interkorrelationsberechnung (75, 76, 77) zwischen den Signalen von den Filtern von Rang i (71) der Mittenfrequenz $Fech_l$/L des Kanals in der Größenordnung l mit wenigstens den Signalen von den Filtern von Rang i+k oder i-k (72, 73, 74) des Kanals der Größenordnung m, mit der Mittenfrequenz (i+k)$Fech_m$/M oder (i-k)$Fech_m$/M;
   - Durchführen der Erkennung (78) der Signale durch Vergleichen der Leistung des Signals am Ausgang der Interkorrelationsberechnung mit Bezug auf einen gegebenen Schwellenwert, wobei die Frequenz eines erkannten Signals anhand der Kenntnis der Ränge der Filter identifiziert wird.

2. Verfahren nach Anspruch 1, **dadurch gekennzeichnet, dass** die Abtastfrequenzen der Kanäle (1, 2, 3, 4) auf eine solche Weise bestimmt werden, dass die Abstände zwischen den gefalteten Frequenzen, die den Kanälen entsprechen, in dem Suchband (61) konstant sind.

3. Verfahren nach einem der vorherigen Ansprüche, **dadurch gekennzeichnet, dass** die Frequenzsuchdomäne (61) durch Modifizieren der Abtastfrequenzen der Kanäle (1, 2, 3, 4) im Laufe der Zeit verschoben wird.

4. Verfahren nach einem der vorherigen Ansprüche, **dadurch gekennzeichnet, dass** die Signale Signale mit geringer Spitzenleistung und langer Pulsdauer sind.

5. Verfahren nach einem der vorherigen Ansprüche, **dadurch gekennzeichnet, dass** es auf ein Amplitudengoniometer angewendet wird, das mehrere Antennen (101, 102, 103, 104, 105, 106) umfasst, wobei wenigstens zwei Empfangskanäle (1, 2, 3, 4) mit jeder Antenne verbunden sind.

6. Verfahren nach Anspruch 5, **dadurch gekennzeichnet, dass** für eine gegebene Antenne (104) die Interkorrelationsberechnung zwischen den auf den beiden Empfangskanälen (1, 2) der Antenne empfangenen Signalen erfolgt, wobei das Ergebnis der Berechnung Zugang zu der Amplitude der Signale bietet, die zum Schätzen ihrer Ankunftsrichtung notwendig ist.

7. Verfahren nach einem der Ansprüche 5 oder 6, **dadurch gekennzeichnet, dass** eine Interkorrelationsberechnung zwischen den von zwei benachbarten Antennen (103, 104) empfangenen Signalen erfolgt.

8. Verfahren nach einem der vorherigen Ansprüche, **dadurch gekennzeichnet, dass** es auf ein Frequenzambiguitätsinterferometer angewendet wird, wobei ein Empfangskanal (1, 2, 3, 4) mit jeder Antenne (21, 22, 23, 24) des Interferometers verbunden ist.

9. Verfahren nach Anspruch 8, **dadurch gekennzeichnet, dass**, da jeder Empfangskanal (1, 2, 3, 4) mit einer anderen Antenne (21, 22, 23, 24) assoziiert ist, die relative Phase eines Signals aus den unterschiedlichen Interkorrelationsberechnungen extrahiert wird, durchgeführt zwischen den unterschiedlichen paarweise genommenen Kanälen.

10. Verfahren nach einem der vorherigen Ansprüche, **dadurch gekennzeichnet, dass** es parallel zu einer Erkennungsverarbeitung durchgeführt wird, angewendet auf die Erkennung von gepulsten Signalen.

11. Digitaler Empfänger, **dadurch gekennzeichnet, dass** er das Verfahren nach einem der vorherigen Ansprüche durchführt.


**Claims**

1. A method for detecting signals in a frequency-ambiguous digital receiver by aliasing of the frequency spectra, said receiver comprising at least two reception pathways (1, 2, 3, 4), **characterized in that**, with a sampling frequency for said signals being specific to each pathway, said method comprises at least the following steps:

   - determining a frequency-wise search band (61) bounded above by a frequency ($F_{max}$) which is less than or equal to half the smallest sampling frequency from among the sampling frequencies of said pathways, said search band being contained in one and the same ambiguity rank in relation to the sampling frequencies of said pathways;
   - determining the sampling frequencies of said pathways (1, 2, 3, 4) in such a way that the aliased frequencies corresponding to said pathways are a monotonic function of the true frequency of said signals in said search band (61);
   - digitally filtering said signals in said reception pathways (1, 2, 3, 4) in banks of filters (701, 702, 703, 704) of like central frequency which is a multiple of a quantity $1/T$ and of like width equal to said quantity $1/T$, $Fech_l$ and $Fech_m$ being respectively the sampling frequency of any pathway of order $l$ and of any pathway of order $m$ from among said pathways (1, 2, 3, 4), $Fech_l/L = Fech_m/M = 1/T$, $L$ and $M$ being integer numbers;
   - in said search band (61), the frequency aliasing of the signal in the pathway of order $l$ giving a response in the filter of rank i (71) and in a pathway of order m a response in the filter of rank k+i or i-k (72, 73, 74), carrying out a computation of inter-correlation (75, 76, 77) between the signals arising from the filters of rank i (71) of central frequency $Fech_l/L$ of the pathway of order $l$ with at least the signals arising from the filters of rank i+k or i-k (72, 73, 74) of the pathway of order m, of central frequency $(i+k)Fech_m/M$ or $(i-k)Fech_m/M$;
   - carrying out the detection (78) of the signals by comparing the power of the signal on output from the inter-correlation computation with respect to a given threshold, the frequency of a detected signal being identified by the knowledge of the ranks of said filters.

**2.** The method as claimed in claim 1, **characterized in that** the sampling frequencies of said pathways (1, 2, 3, 4) are determined in such a way that the disparities between the aliased frequencies corresponding to said pathways are constant in said search band (61).

**3.** The method as claimed in either of the preceding claims, **characterized in that** said frequency-wise search domain (61) is displaced by modifying the sampling frequencies of said pathways (1, 2, 3, 4) in the course of time.

**4.** The method as claimed in any one of the preceding claims, **characterized in that** said signals are signals of low peak power and of long pulse duration.

**5.** The method as claimed in any one of the preceding claims, **characterized in that** it is applied to an amplitude goniometer comprising several antennas (101, 102, 103, 104, 105, 106), at least two reception pathways (1, 2, 3, 4) being connected to each antenna.

**6.** The method as claimed in claim 5, **characterized in that**, for a given antenna (104), the inter-correlation computation is performed between the signals received on the two reception pathways (1, 2) of the antenna, the result of said computation affording access to the amplitude of the signals which is necessary for estimating their direction of arrival.

**7.** The method as claimed in either one of claims 5 and 6, **characterized in that** an inter-correlation computation is performed between the received signals of two adjacent antennas (103, 104).

**8.** The method as claimed in any one of the preceding claims, **characterized in that** it is applied to a frequency-ambiguous interferometer, a reception pathway (1, 2, 3, 4) being linked to each antenna (21, 22, 23, 24) of said interferometer.

**9.** The method as claimed in claim 8, **characterized in that**, each reception pathway (1, 2, 3, 4) being associated with a different antenna (21, 22, 23, 24), the relative phase of a signal is extracted on the basis of the various inter-correlation computations performed between the various pathways taken pairwise.

**10.** The method as claimed in any one of the preceding claims, **characterized in that** it is performed in parallel with a detection processing suitable for detecting pulsed signals.

**11.** A digital receiver, **characterized in that** it implements the method as claimed in any one of the preceding claims.

FIG.1

FIG.2

FIG.3

EP 3 218 738 B1

FIG.4

FIG.5

FIG.6

FIG.7

FIG.8

FIG.9

**RÉFÉRENCES CITÉES DANS LA DESCRIPTION**

**Documents brevets cités dans la description**

- EP 1618407 A1
- FR 2897441 A1
- FR 1400514
- FR 3018136